# FASCICULE DE BREVET EUROPEEN

(11) **EP 1 462 815 B1**
(45) Date de publication et mention de la délivrance du brevet: **14.05.2008**
(21) Numéro de dépôt: 04290555.4
(22) Date de dépôt: 01.03.2004
(51) Int. Cl.: G01R 31/36

(54) **Système et procédé de détermination de l'état de charge instantané d'une batterie, et utilisation de ce procédé dans un gestionnaire de charge**
Verfahren und Vorrichtung zur Bestimmung des Ladeszustands einer Batterie und Verwendung eines solchen Verfahrens in einem Ladungsmanager
System and method of determining the state of charge of a battery and use of such a method for charge management

(30) Priorité: 26.03.2003 FR 0303731
(43) Date de publication de la demande: 29.09.2004
(73) Titulaire: Peugeot Citroën Automobiles S.A., 78140 Vélizy Villacoublay (FR)
(72) Inventeur: Chabot Petrault, Christine, 92250 La Garenne-Colombes (FR); Bianchi, Valérie, 92400 Courbevoie (FR)
(74) Mandataire: Habasque, Etienne J. Jean-François

(56) Documents cités:
- DE-A- 10 203 810
- US-A1- 2002 130 637
- PILLER S ET AL: "Methods for state-of-charge determination and their applications" JOURNAL OF POWER SOURCES, ELSEVIER SEQUOIA S.A. LAUSANNE, CH, vol. 96, no. 1, 1 juin 2001 (2001-06-01), pages 113-120, XP004298736 ISSN: 0378-7753

## Description

La présente invention concerne un système de détermination d'un état de charge instantané d'une batterie de stockage d'énergie notamment pour véhicule automobile.

Avec l'augmentation rapide du nombre de consommateurs électriques embarqués sur véhicules, il est nécessaire d'effectuer une gestion intelligente du fonctionnement de l'alternateur et de la batterie afin notamment de pouvoir toujours garantir le démarrage du véhicule.

Cette gestion doit également permettre de dimensionner au plus juste l'alternateur et la batterie en vue de baisser les coûts de production.

La mise en place de cette gestion électrique sur véhicule, nécessite de connaître à tout moment l'état de charge instantané de la batterie.

Des systèmes de détermination d'un état de charge instantané d'une batterie existent déjà dans l'état de la technique. Mais pour fonctionner, ces systèmes nécessitent la connaissance de la tension aux bornes de la batterie, de la température interne de la batterie, ainsi qu'une mesure du courant transitant dans la batterie.

Le document US 200210130637 décrit un système de détermination d'un état de charge d'une batterie de stockage d'énergie. Le système comprend un moyen de calcul d'un filtre de Kalman recevant en entrée des informations concernant un état de charge permanent de la batterie, la résistance interne de celle-ci, ainsi qu'une valeur de chute de tension interne de la batterie.

Le document Piller S et al : « Methods for state-of-charge determination and their applications » Journal of Power Sources divulgue l'utilisation de différents modèles de filtres de Kalman choisis en fonction du type du moteur d'un véhicule (véhicule hybride, diesel ...).

DE 102 03 810 décrit un système de détermination d'un état de charge et d'une capacité de puissance d'une batterie de stockage d'énergie par estimation d'informations considérées dans deux conditions de fonctionnement différent de la batterie de stockage.

Un but de la présente invention est d'élaborer un système de détermination de l'état de charge instantané de la batterie qui soit apte à fonctionner sans l'utilisation d'un capteur de courant. L'absence de ce capteur entraîne notamment une économie substantielle sur le prix du système de détermination ainsi qu'un gain en terme d'encombrement sous capot.

En particulier, un but de la présente invention est de déterminer un état de charge instantané sans capteur de courant, et avec une erreur maximale de plus ou moins 10 %, dans les plages de fonctionnement suivantes :
- état de charge variant de 60 à 100 % (100 % correspondant à une batterie totalement chargée) ;
- plage de température allant de - 20°C à + 50°C.

A cet effet, l'invention a pour objet un système de détermination d'un état de charge instantané d'une batterie de stockage d'énergie, notamment pour véhicule automobile, caractérisé en ce qu'il comporte en outre un moyen de calcul d'un filtre de Kalman étendu recevant en entrée des informations concernant l'état de charge de la batterie initialisé, la tension mesurée aux bornes de la batterie et une température de la batterie pour déterminer l'état de charge instantané de la batterie, caractérisé en ce que le moyen de calcul du filtre de Kalman comprend :
- une unité de calcul du décalage temporel, recevant en entrée des informations concernant l'état de charge initialisé et l'état de charge estimé à l'instant t +1, pour déterminer un état de charge estimé, à l'instant t ;
- une première unité de calcul de prédiction recevant en entrée des informations concernant l'état de charge estimé et la température de la batterie, pour calculer un état de charge prédit à l'instant t+1 ;
- une seconde unité de calcul de prédiction recevant en entrée des informations concernant l'état de charge prédit et la température de la batterie pour déterminer la tension prédite à l'instant t+1;
- un comparateur pour calculer un écart de tension entre la tension mesurée aux bornes de la batterie et une tension prédite ;
- une unité de calcul d'un gain correcteur recevant en entrée des informations concernant l'écart de tension, la température de la batterie et la tension prédite, pour calculer un gain correcteur; et
- une unité de calcul d'estimation recevant en entrée des informations concernant l'état de charge prédit et le gain correcteur pour calculer l'état de charge instantané de la batterie.

Un deuxième but de la présente invention est de réaliser un procédé de détermination de l'état de charge instantané.

Un troisième but de la présente invention est d'utiliser ce procédé de détermination d'un état de charge dans un gestionnaire de batterie.

L'invention sera mieux comprise à la lecture de la description qui va suivre, donnée uniquement à titre d'exemple et faite en se référant aux dessins annexés, sur lesquels :
- la figure 1 représente de façon schématique un système de détermination selon l'invention ;
- la figure 2 représente de façon schématique un moyen de calcul d'un filtre de Kalman entrant dans la constitution du système de détermination ;
- les figures 3 à 6 représentent différentes courbes illustrant des résultats obtenus par l'utilisation du système de détermination selon l'invention.

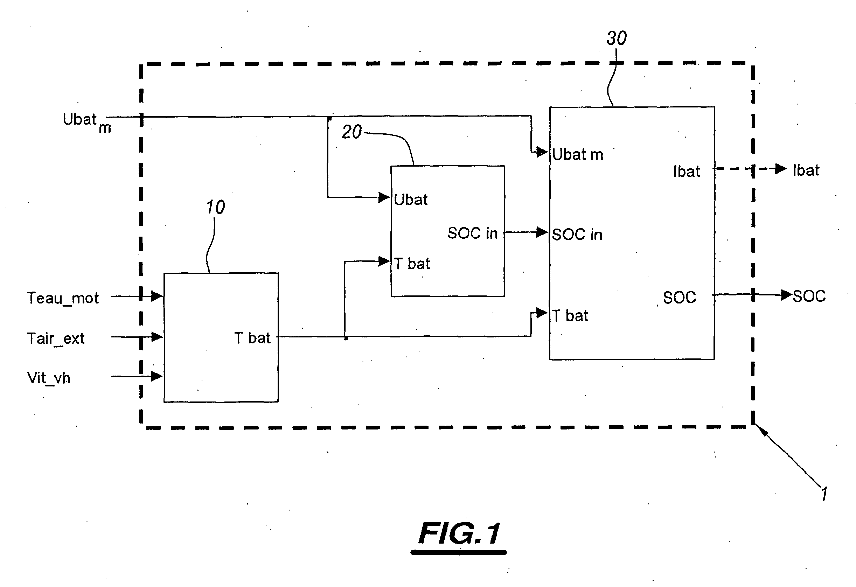

La figure 1 représente de façon schématique un système de détermination 1 d'un état de charge instantané d'une batterie notamment pour véhicule automobile. Ce système reçoit en entrée une information de tension mesurée aux bornes de la batterie U bat m, une mesure de la température de l'eau ou du liquide de refroidissement du moteur T eau-mot, une mesure de la température de l'air extérieur T air-ext, et une mesure de la vitesse du véhicule Vit-vh, et délivre l'état de charge instantané estimé de la batterie SOC ainsi qu'une estimation du courant de la batterie I bat.

Ce système est composé de trois moyens de calcul :
- un moyen de calcul de température 10 qui permet de déterminer la température de la batterie T bat à partir des informations concernant la température de l'eau moteur T eau-mot, la température de l'air extérieur T air-ext et la vitesse du véhicule Vit-vh. Ce moyen de calcul peut également être remplacé par une sonde de température de mesure directe de la température de la batterie.
- un moyen de calcul d'initialisation 20 qui permet d'une part, de calculer l'état de charge de la batterie dans les premières utilisations du véhicule et, d'autre part, d'initialiser cet état de charge au cours de la vie du véhicule. En effet, l'estimation de l'état de charge de la batterie dérive légèrement au cours du temps en raison de l'imprécision de la mesure de la tension de batterie, de l'imprécision de la mesure de la température de la batterie, du vieillissement de la batterie, d'un changement de batterie ou des variations du rendement de la charge de la batterie. Afin de compenser ces dérives, le moyen de calcul d'initialisation effectue périodiquement des calculs pour déterminer l'état de charge initialisé de la batterie SOC in. Le moyen de calcul d'initialisation 20 reçoit en entrée des informations concernant la tension mesurée aux bornes de la batterie et la température de la batterie.
- un moyen de calcul d'un filtre de Kalman étendu 30 qui détermine l'état de charge instantané de la batterie SOC. Il reçoit en entrée la tension batterie mesurée U bat m, la température de la batterie T bat et l'état de charge de la batterie initialisé SOC in.

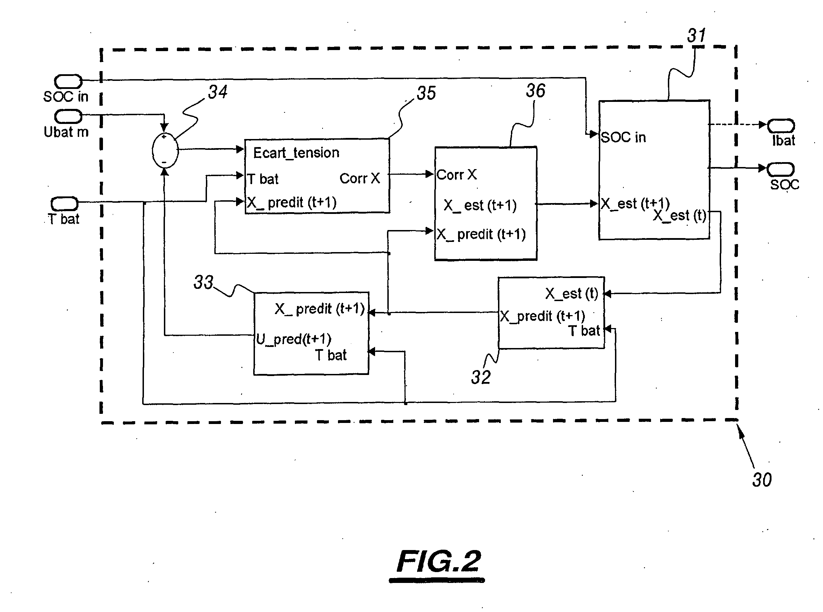

La figure 2 représente de façon schématique et détaillée ce moyen de calcul 30 du filtre de Kalman étendu.

D'une manière générale, un filtre de Kalman est un observateur dynamique qui fonctionne selon le principe suivant :
- entrée d'un état initial et d'un courant bruité,
- calcul d'une variable estimée,
- comparaison de cette variable estimée avec une variable mesurée pour construire une matrice de correction également appelée « gain correcteur »,
- le gain correcteur est appliqué à l'état initial pour déterminer l'état instantané.

Ainsi, le filtre de Kalman permet de calculer un état instantané à partir de l'erreur entre une variable mesurée et une variable estimée par le système. Généralement, le filtre de Kalman converge après plusieurs calculs successifs vers une valeur proche de la réalité. Plus le courant bruité est proche du courant réel transitant dans la batterie, plus le filtre de Kalman calcule rapidement une valeur estimée proche de la valeur mesurée.

Dans la présente invention, le filtre de Kalman a été utilisé pour déterminer l'état de charge instantané d'une batterie de véhicule.

A cet effet et comme visible sur la figure 2, le moyen de calcul 30 du filtre de Kalman comprend :
- Une unité de calcul du décalage temporel 31 qui détermine un état de charge estimé de la batterie à l'instant t. Cette unité 31 reçoit, en entrée, des informations concernant un état de charge initiale SOC in et un état de charge estimé X_est(t+1) à l'instant t+1. L'unité de décalage temporel 31 réalise son premier calcul à partir de l'état de charge nominal de la batterie, la tension U bat m à ses bornes et la température de la batterie T bat.
- Une première unité de calcul de prédiction 32 qui calcule un état de charge prédit X_predit(t+1) à l'instant t+1. Cette unité reçoit, en entrée, des informations concernant l'état de charge estimé X_est(t) à l'instant t et la température de la batterie T bat.
- Une seconde unité de calcul de prédiction 33 qui détermine une tension prédite U_pred(t+1) aux bornes de la batterie à l'instant t+1. Cette unité 33 reçoit, en entrée, des informations concernant l'état de charge prédit X_pred(t+1) à l'instant t+1 et la température de la batterie T bat.
- Un comparateur 34 qui calcule un écart de tension entre la tension mesurée U bat m aux bornes de la batterie et la tension prédite U_pred(t+1) aux bornes de la batterie.
- Une unité de calcul d'un gain correcteur 35 qui calcule une matrice de gain correcteur Corr X. Cette unité 35 reçoit, en entrée, des informations concernant l'écart de tension, la température de la batterie T bat et l'état de charge prédit X_predit(t+1) à l'instant t+1.
- Une unité de calcul d'estimation 36 qui calcule l'état de charge instantané SOC. Cette unité 36 reçoit, en entrée, des informations de l'état de charge prédit X_predit (t+1) et le gain correcteur Corr X.

Ainsi, grâce à la présente invention, l'état de charge instantané est déterminé sans capteur de courant.

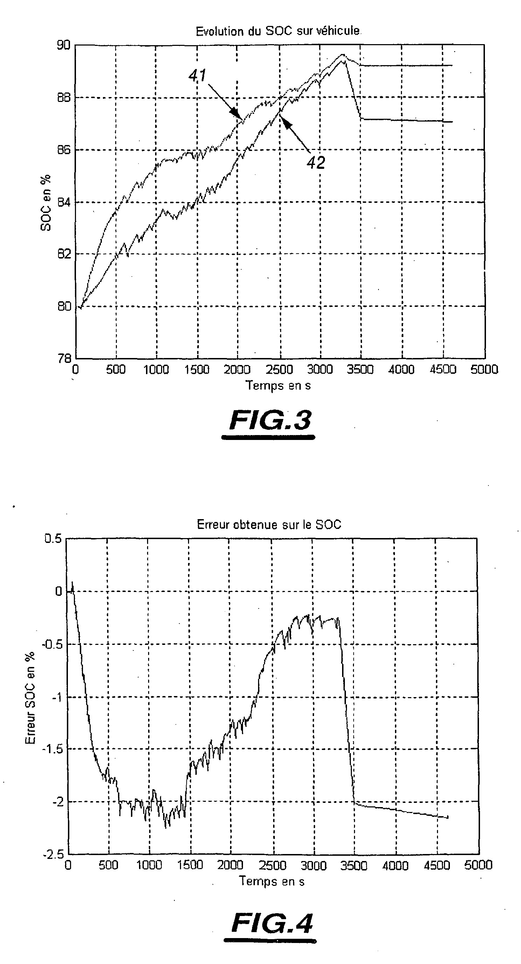

Les figures 3 et 4 représentent des courbes de l'évolution de l'état de charge instantané lors d'un roulage avec un état de charge initial de la batterie de 80 % et une consommation moyenne de 10 ampères.

En particulier, la figure 3 représente une première courbe 41 obtenue par le système de détermination 1 selon la présente invention et, une seconde courbe 42 obtenue par intégration d'une mesure de courant obtenue par un capteur de courant.

La figure 4 représente une courbe de l'évolution du pourcentage d'erreur entre l'état de charge instantané calculé avec et sans capteur de courant.

Ainsi, on peut constater que le pourcentage d'erreur de l'état de charge instantané calculé par le système selon la présente invention, est inférieur à 10 % pour une consommation moyenne de 10 ampères.

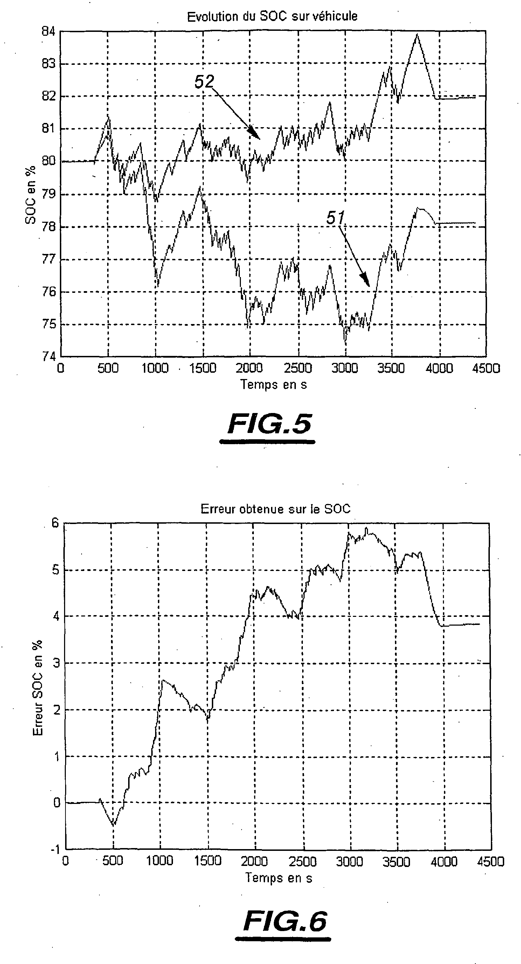

Les figures 5 et 6 représentent également l'évolution de l'état de charge instantané lors d'un roulage avec un état de charge initial de la batterie de 80 % et une consommation moyenne de 40 ampères.

En particulier, la figure 5 représente une première courbe 51 obtenue par le système de détermination 1 et, une seconde courbe 52 obtenue par le capteur de courant.

La figure 6 représente une courbe de l'évolution du pourcentage d'erreur correspondant. Ce pourcentage est, à nouveau, inférieur à 10 % pour une consommation moyenne de 40 ampères.

Ainsi, ces courbes permettent de vérifier que le système selon l'invention permettent d'obtenir un état de charge instantané SOC égal, à plus ou moins 10 %, à l'état de charge calculé en utilisant un capteur de courant.

Ce système et ce procédé de détermination de l'état de charge instantané SOC sont avantageusement utilisés dans un gestionnaire d'état de charge de la batterie.

Ce gestionnaire est apte à commander des actions correctrices en cas de batterie insuffisamment chargée. Une action correctrice peut par exemple consister à faire fonctionner l'alternateur dans un mode où il produit plus d'électricité.

De plus, ce gestionnaire pourrait, par exemple, être apte à couper des fonctions électriques dites « mineures », telles que la radio, la climatisation ou l'assistance au stationnement au profit de fonctions électriques dites « majeures », telles que les phares ou le démarrage du moteur lorsque la batterie est insuffisamment chargée.

## Revendications

1. Système de détermination (1) d'un état de charge instantané (SOC) d'une batterie de stockage d'énergie, notamment pour véhicule automobile, le système comportant en outre un moyen de calcul (30) d'un filtre de Kalman étendu recevant en entrée, des informations concernant un état de charge de la batterie initialisé (SOC-in), une tension mesurée (U bat m) aux bornes de la batterie et une température de la batterie (T bat) pour déterminer l'état de charge instantané (SOC) de la batterie,
**caractérisé en ce que** le moyen de calcul (30) du filtre de Kalman comprend :
- une unité de calcul du décalage temporel (31), recevant en entrée des informations concernant l'état de charge initialisé (SOC-in) et l'état de charge estimé (X_est(t+1)) à l'instant t +1, pour déterminer un état de charge estimé (X_est(t)), à l'instant t ;
- une première unité de calcul de prédiction (32) recevant en entrée des informations concernant l'état de charge estimé (X_est(t)) et la température de la batterie (T bat), pour calculer un état de charge prédit (X_pred(t +1)) à l'instant t+1 ;
- une seconde unité de calcul de prédiction (33) recevant en entrée des informations concernant l'état de charge prédit (X_pred(t +1)) et la température de la batterie (T bat) pour déterminer la tension prédite (U_pred(t+1)) à l'instant t+1;
- un comparateur (34) pour calculer un écart de tension entre la tension mesurée aux bornes de la batterie (U bat m) et une tension prédite (U_pred(t+1)) ;
- une unité de calcul d'un gain correcteur (35) recevant en entrée des informations concernant l'écart de tension, la température de la batterie (T bat) et la tension prédite (U_red(t+1)), pour calculer un gain correcteur (Corr X); et
- une unité de calcul d'estimation (36) recevant en entrée des informations concernant l'état de charge prédit (X_pred(t +1)) et le gain correcteur (Corr X) pour calculer l'état de charge instantané de la batterie (SOC).

2. Système selon la revendication 1, **caractérisé en ce qu'**il est également apte à déterminer le courant (I bat) transitant dans la batterie.

3. Système selon la revendication 1 ou 2, **caractérisé en ce qu'**il comporte, en outre, un moyen de calcul de la température (10) de la batterie recevant en entrée des informations concernant la température de l'eau de refroidissement du moteur, la température de l'air extérieur et la vitesse du véhicule, pour déterminer la température de la batterie.

4. Système selon l'une quelconque des revendications précédentes, **caractérisé en ce qu'**il comporte, en outre, un moyen de calcul d'initialisation (20) recevant, en entrée, des informations concernant la tension mesurée aux bornes de la batterie (U bat m) et la température de la batterie (T bat) pour déterminer l'état de charge initialisé de la batterie (SOC-in).

5. Procédé de détermination d'un état de charge instantané (SOC) d'une batterie de stockage d'énergie, notamment pour véhicule automobile, le procédé comportant, en outre, une étape de calcul d'un filtre de Kalman étendu à partir d'informations concernant uniquement un état de charge initialisé (SOC-in), une tension mesurée (U bat m) aux bornes de la batterie et une température de la batterie (T bat) pour déterminer l'état de charge instantané (SOC) de la batterie, **caractérisé en ce que** ladite étape de calcul comporte en outre les étapes suivantes :
- une étape de calcul du décalage temporel, dans laquelle un état de charge estimé X_est(t) à l'instant t est déterminé à partir d'informations concernant l'état de charge initial (SOC-in) et l'état de charge estimé (X_est(t+1)) à l'instant +1;
- une étape de calcul de prédiction d'un état de charge prédit (X_pred(t +1)) à l'instant t+1 à partir d'informations concernant l'état de charge estimé (X_est(t)) et la température de la batterie (T bat) ;
- une étape de calcul de prédiction d'une tension prédite (U_pred(t+1)) aux bornes de la batterie, à l'instant t+1, à partir d'informations concernant l'état de charge prédit (X_pred(t +1)) et la température de la batterie (T bat);
- une étape de calcul d'un écart de tension entre la tension mesurée (U bat m) aux bornes de la batterie et la tension prédite (U_pred(t+1)) ;
- une étape de calcul d'un gain correcteur (Corr X) à partir d'informations concernant l'écart de tension, la température de la batterie (T bat) et la tension prédite (U_pred(t+1)) ; et
- une étape de calcul d'estimation de l'état de charge instantané de la batterie (SOC) à partir d'informations concernant l'état de charge prédit (X_pred(t +1)) et le gain correcteur (Corr X).

6. Utilisation d'un procédé de détermination d'un état de charge instantané d'une batterie tel que revendiqué en revendication 5, dans un gestionnaire d'état de charge de batterie.

## Claims

1. System for determining (1) an instantaneous state of charge (SOC) of an energy storage battery, particularly for a motor vehicle, the system additionally comprising a means for calculating (30) an extended Kalman filter receiving at input information on an initialised state of charge of the battery (SOC-in), a voltage measured (U bat m) at the battery terminals and a battery temperature (T bat) in order to determine the instantaneous state of charge (SOC) of the battery, **characterised in that** the Kalman filter calculation means (30) includes:
- a unit for calculating the time shift (31), receiving at input information on the initialised state of charge (SOC-in) and the estimated state of charge (X_est(t+1)), at the instant t+1,in order to determine an estimated state of charge (X_est(t)), at the instant t;
- a first unit for calculating prediction (32) receiving at input information on the estimated state of charge (X_est(t)) and the battery temperature (T bat), in order to calculate a predicted state of charge (X_pred(t+1)) at the instant t+1;
- a second unit for calculating prediction (33) receiving at input information on the predicted state of charge (X_pred(t+1)) and the battery temperature (T bat) in order to determine the predicted voltage (U_pred(t+1)) at the instant t+1;
- a comparator (34) for calculating a voltage deviation between the voltage measured at the battery terminals (U bat m) and a predicted voltage (U_pred(t+1));
- a unit for calculating a corrective gain (35) receiving at input information on the voltage deviation, the battery temperature (T bat) and the predicted voltage (U_pred(t+1)), in order to calculate a corrective gain (Corr X); and
- a unit for calculating an estimation (36) receiving at input information on the predicted state of charge (X_pred(t+1)) and the corrective gain (Corr X) in order to calculate the instantaneous state of charge of the battery (SOC).

2. System according to claim 1, **characterised in that** it is also capable of determining the current (1 bat) passing through the battery.

3. System according to claim 1 or 2, **characterised in that** it additionally comprises a means for calculating the temperature (10) of the battery receiving at input information on the temperature of the engine cooling water, the temperature of the external air and the speed of the vehicle, in order to determine the temperature of the battery.

4. System according to any one of the previous claims, **characterised in that** it additionally comprises a means for calculating initialisation (20) receiving at input information on the voltage measured at the battery terminals (U bat m) and the battery temperature (T bat) in order to determine the initialised state of charge of the battery (SOC-in).

5. Method of determining an instantaneous state of charge (SOC) of an energy storage battery, particularly for a motor vehicle, the method additionally comprising a stage of calculating an extended Kalman filter from information relating only to an initialised state of charge (SOC-in), a voltage measured (U bat m) at the battery terminals and a battery temperature (T bat) in order to determine the instantaneous state of charge (SOC) of the battery, **characterised in that** said calculation stage additionally comprises the following stages:
- a stage of calculating the time shift, wherein an estimated state of charge X_est(t) at the instant t is determined from information on the initial state of charge (SOC-in) and the estimated state of charge (X_est(t+1)) at the instant t+1;
- a stage of calculating prediction of a predicted state of charge (X_pred(t+1)) at the instant t+1 from information on the estimated state of charge (X_est(t)) and the battery temperature (T bat);
- a stage of calculating prediction of a predicted voltage (U_pred(t+1)) at the battery terminals, at the instant t+1, from information on the predicted state of charge (X_pred(t+1)) and the battery temperature (T bat);
- a stage of calculating a voltage deviation between the voltage measured (U bat m) at the battery terminals and the predicted voltage (U_pred(t+1));
- a stage of calculating a corrective gain (Corr X) from information on the voltage deviation, the battery temperature (T bat) and the predicted voltage (U_pred(t+1)); and
- a stage of calculating the instantaneous state of charge of the battery (SOC) from information on the predicted state of charge (X_pred(t+1)) and the corrective gain (Corr X).

6. Use of a method for determining the instantaneous state of charge of a battery as claimed in claim 5, in a battery state of charge operator.

## Patentansprüche

1. System für das Bestimmen (1), zu einem bestimmten Zeitpunkt, eines Ladezustands (SOC) einer Batterie für das Speichern von Energie, im Besonderen für Kraftfahrzeuge, wobei das System des Weiteren ein Mittel für das Berechnen (30) eines erweiterten Kalman-Filters enthält, das als Eingabe Informationen bezüglich des initialisierten Ladezustands der Batterie (SOC-in), einer an den Anschlüssen der Batterie gemessenen Spannung (U bat m) und einer Temperatur der Batterie (T bat) empfängt, um den Ladezustand (SOC) der Batterie zu einem bestimmten Zeitpunkt zu bestimmen,
**dadurch gekennzeichnet, dass** das Mittel für das Berechnen (30) des Kalman-Filters folgendes umfasst:
- eine Einheit für das Berechnen der zeitlichen Verschiebung (31), die als Eingabe Informationen bezüglich des initialisierten Ladezustands (SOC-in) und des geschätzten Ladezustands (X_est(t+1)) zum Zeitpunkt t+1 empfängt, um einen geschätzten Ladezustand (X_est(t)) zum Zeitpunkt t zu bestimmen;
- eine erste Einheit für das Berechnen der Prädiktion (32), die als Eingabe Informationen bezüglich des geschätzten Ladezustands (X_est(t)) und der Temperatur der Batterie (T bat) empfängt, um einen vorhergesagten Ladezustand (X_pred(t+1)) zum Zeitpunkt t+1 zu berechnen;
- eine zweite Einheit für das Berechnen der Prädiktion (33), die als Eingabe Informationen bezüglich des vorhergesagten Ladezustands (X_pred(t+1)) und der Temperatur der Batterie (T bat) empfängt, um die vorhergesagte Spannung (U_pred(t+1)) zum Zeitpunkt t+1 zu bestimmen;
- einen Komparator (34), um einen Spannungsunterschied zwischen der an den Anschlüssen der Batterie gemessenen Spannung (U bat m) und einer vorhergesagten Spannung (U_pred(t+1)) zu berechnen;
- eine Einheit für das Berechnen eines Korrektur-Gains (35), die als Eingabe Informationen bezüglich des Spannungsunterschieds, der Temperatur der Batterie (T bat) und der vorhergesagten Spannung (U_pred(t+1)) empfängt, um einen Korrektur-Gain (Corr X) zu berechnen; und
- eine Einheit für das Berechnen der Schätzung (36), die als Eingabe Informationen bezüglich des vorhergesagten Ladezustands (X_pred(t+1)) und des Korrektur-Gains (Corr X) empfängt, um den Ladezustand der Batterie (SOC) zu einem bestimmten Zeitpunkt zu berechnen.

2. System gemäß Anspruch 1, **dadurch gekennzeichnet, dass** es ebenfalls für das Bestimmen des Stroms (I bat), der in der Batterie fließt, geeignet ist.

3. System gemäß Anspruch 1 oder 2, **dadurch gekennzeichnet, dass** es des Weiteren ein Mittel für das Berechnen der Temperatur (10) der Batterie enthält, das als Eingabe Informationen bezüglich der Temperatur des Kühlwassers des Motors, der Temperatur der Außenluft und der Geschwindigkeit des Fahrzeugs empfängt, um die Temperatur der Batterie zu bestimmen.

4. System gemäß einem der vorangehenden Ansprüche, **dadurch gekennzeichnet, dass** es des Weiteren ein Mittel für das Berechnen der Initialisierung (20) enthält, das als Eingabe Informationen bezüglich der an den Anschlüssen der Batterie gemessenen Spannung (U bat m) und der Temperatur der Batterie (T bat) empfängt, um den initialisierten Ladezustand der Batterie (SOC-in) zu bestimmen.

5. Verfahren für das Bestimmen, zu einem bestimmten Zeitpunkt, eines Ladezustands (SOC) einer Batterie für das Speichern von Energie, im Besonderen für Kraftfahrzeuge, wobei das Verfahren des Weiteren einen Schritt des Berechnens durch einen erweiterten Kalman-Filter ausgehend von Informationen, die ausschließlich einen initialisierten Ladezustand (SOC-in), eine an den Anschlüssen der Batterie gemessene Spannung (U bat m) und eine Temperatur der Batterie (T bat) betreffen, um den Ladezustand (SOC) der Batterie zu einem bestimmten Zeitpunkt zu bestimmen, **dadurch gekennzeichnet, dass** dieser Schritt des Berechnens des Weiteren folgende Schritte enthält:
- einen Schritt des Berechnens der zeitlichen Verschiebung, wobei ein geschätzter Ladezustand X_est(t) zum Zeitpunkt t ausgehend von Informationen bezüglich des initialen Ladezustands (SOC-in) und des geschätzten Ladezustands (X_est(t+1)) zu einem Zeitpunkt t+1 bestimmt wird;
- einen Schritt des Berechnens der Prädiktion eines vorhergesagten Ladezustands (X_pred(t+1)) zum Zeitpunkt t+1 ausgehend von Informationen bezüglich des geschätzten Ladezustands (X_est(t)) und der Temperatur der Batterie (T bat);
- einen Schritt des Berechnens der Prädiktion einer vorhergesagten Spannung (U_pred(t+1)) an den Anschlüssen der Batterie zu einem Zeitpunkt t+1 ausgehend von Informationen bezüglich des vorhergesagten Ladezustands (X_pred(t+1)) und der Temperatur der Batterie (T bat);
- einen Schritt des Berechnens eines Spannungsunterschieds zwischen der an den Anschlüssen der Batterie gemessenen Spannung (U bat m) und der vorhergesagten Spannung (U_pred(t+1)):
- einen Schritt des Berechnens eines Korrektur-Gains (Corr X) ausgehend von Informationen bezüglich des Spannungsunterschieds, der Temperatur der Batterie (T bat) und der vorhergesagten Spannung (U_pred(t+1)); und
- einen Schritt des Berechnens der Schätzung des Ladezustands der Batterie (SOC) zu einem bestimmten Zeitpunkt ausgehend von Informationen bezüglich des vorhergesagten Ladezustands (X_pred(t+1)) und des Korrektur-Gains (Corr X).

6. Verwendung eines Verfahrens für das Bestimmen, zu einem bestimmten Zeitpunkt, eines Ladezustands einer Batterie wie in Anspruch 5 beansprucht in einem Verwaltungsprogramm des Ladezustands einer Batterie.
